# EUROPÄISCHE PATENTANMELDUNG

(11) **EP 3 726 338 A1**
(43) Veröffentlichungstag der Anmeldung: **21.10.2020**
(21) Anmeldenummer: 19169973.5
(22) Anmeldetag: 17.04.2019
(51) Int. Cl.: G06F 1/20, F28D 21/00

(54) **KOMPONENTEN FÜR EIN FLUIDKÜHLSYSTEM SOWIE FLUIDKÜHLSYSTEM MIT DIESEN KOMPONENTEN**

(71) Anmelder: TechN GmbH, 12099 Berlin (DE)
(72) Erfinder: KOHL, Nikolaus, 10999 Berlin (DE); GUSCHAUSKI, Thilo, 10439 Berlin (DE)
(74) Vertreter: Pfenning, Meinig & Partner mbB

(57) **Zusammenfassung**

Die Erfindung betrifft ein erstes Modul, insbesondere für ein Fluidkühlsystem, umfassend eine Steuereinheit, eine erste Kommunikationseinheit, eine Pumpe für ein Kühlfluid, und einen ersten Wärmetauscher,
wobei die erste Kommunikationseinheit ausgebildet ist zum Empfangen von Signalen von mindestens einem zweiten Modul, wobei die Signale ein Identifikationsmerkmal des zweiten Moduls aufweisen,
wobei die Steuereinheit anhand des Identifikationsmerkmals ausgebildet ist zum
- Identifizieren des zweiten Moduls,
- Überprüfen, ob das zweite Modul systemkompatibel oder berechtigt ist, und
- Anschalten der Pumpe und/oder des ersten Wärmetauschers in Abhängigkeit eines Vorliegens des systemkompatiblen oder berechtigten zweiten Moduls.

Weiter betrifft die Erfindung ein zweites Modul sowie ein Kühlfluidsystem mit dem ersten Modul und dem zweiten Modul.

## Beschreibung

Die Erfindung betrifft verschiedene Komponenten insbesondere zur Verwendung in einem Fluidkühlsystem sowie ein Fluidkühlsystem mit diesen Komponenten. Die beschriebenen Komponenten ermöglichen insbesondere einen modularen Aufbau eines Fluidkühlsystems.

Fluidkühlsysteme umfassen üblicherweise zwei Wärmetauscher, die über Fluidleitungen und eine Pumpe fluidisch miteinander verbunden sind. Am ersten Wärmetauscher kann z.B. die Verlustwärme von elektronischen Bauteilen an eine Kühlflüssigkeit übertragen werden. Die Pumpe fördert die erwärmte Kühlflüssigkeit durch die Leitungen zum zweiten Wärmetauscher. Der zweite Wärmetauscher ist z.B. ein Radiator, der von der erwärmten Kühlflüssigkeit durchströmt wird. Hier wird die Wärme der Kühlflüssigkeit über einen Radiator an die Umgebungsluft abgegeben. Diese Wärmeübertragung kann durch den Luftstrom eines Lüfters verbessert werden.

Der Einsatz eines solchen Fluidkühlsystems in Desktop PCs und anderen Elektroniksystemen kann einige Vorteile gegenüber herkömmlichen Luftkühlsystemen bieten. So kann der zweite Wärmetauscher, der die Wärme an die Umgebungsluft überträgt, baulich weiter entfernt von der Wärmequelle positioniert werden. Bei Luftkühlsystemen findet die Wärmeübertragung an die Umgebungsluft in der Regel direkt an der Wärmequelle statt. Durch die räumliche Trennung bei Fluidkühlsystemen können Bauraum- und Gewichtseinschränkungen umgangen werden. Somit können Radiatoren mit einer größeren Oberfläche verwendet und die Kühlleistung gesteigert werden. Aktuell am Massenmarkt vertretene Wasserkühlungen sind fast ausschließlich gekapselte CPU Kühlungen, die in der Regel nicht wartungsfähig und erweiterbar sind und deswegen kaum sinnvoll für andere Komponenten wie die Grafikkarte einsetzbar sind.

Die Erfindung liegt der Aufgabe zugrunde, Komponenten oder ein System zu schaffen, die oder das die Probleme des Standes der Technik zumindest teilweise überwindet.

Die vorliegende Schrift offenbart verschiedene Aspekte, die die gestellte Aufgabe lösen oder die zur Lösung der gestellten Aufgabe beitragen.

Gemäß einem ersten Aspekt wird eine Kupplungsvorrichtung, insbesondere für ein Fluidkühlsystem, vorgeschlagen. Die Kupplungsvorrichtung umfasst hierbei eine erste Kupplungseinheit mit einem ersten Gehäuse, welches ein erstes Teilgehäuse und ein zweites mit dem ersten Teilgehäuse verbindbares Teilgehäuse aufweist. Das erste Teilgehäuse weist eine erste mit einer ersten Fluidleitung verbindbare axiale Durchgangsöffnung, eine erste Signalschnittstelle und eine erste Stirnfläche auf. Weiter weist das zweite Teilgehäuse eine zweite mit einer zweiten Fluidleitung verbindbare axiale Durchgangsöffnung, eine zweite Signalschnittstelle und eine zweite Stirnfläche auf.

Die erste Stirnfläche und die zweite Stirnfläche sind derart komplementär zueinander geformt, dass das erste Teilgehäuse und das zweite Teilgehäuse axial miteinander verbindbar sind, und dass im axial gekoppelten Zustand der beiden Teilgehäuse die Durchgangsöffnungen fluidisch miteinander verbunden sind und die Signalschnittstellen miteinander verbunden sind.

Außerdem sind die beiden Teilgehäuse seitlich miteinander verbindbar, sodass im seitlich gekoppelten Zustand die beiden Teilgehäuse parallel nebeneinander angeordnet sind.

Mit der vorgeschlagenen Kupplungsvorrichtung können die separaten Teilgehäuse seitlich oder axial miteinander zu einer Einheit gefügt werden. Die Kupplungsvorrichtung hat somit einen modularen Aufbau, wodurch sich die Kupplungsvorrichtung durch Vorsehen mehrerer erster Kupplungseinheiten beliebig seriell oder parallel erweitern lässt.

In einer Ausführungsform sind das erste Teilgehäuse und das zweite Teilgehäuse sowohl im seitlich gekoppelten Zustand als auch im axial gekoppelten Zustand formschlüssig miteinander verbunden. In einer Ausführungsform umfasst das erste Teilgehäuse eine erste Seitenfläche und das zweite Teilgehäuse umfasst eine zweite Seitenfläche. Die erste Seitenfläche und die zweite Seitenfläche können derart komplementär zueinander geformt sein, dass die beiden Teilgehäuse seitlich miteinander verbindbar sind. Beispielsweise umfasst eine der Seitenflächen der Teilgehäuse mindestens einen Vorsprung und die jeweils andere Seitenfläche umfasst mindestens einen dazu komplementär geformten Rücksprung. Der Vorsprung greift im seitlich verbundenen Zustand der ersten Kupplungseinheit in den Rücksprung ein. Weiter können die Teilgehäuse ineinandergreifende Profile aufweisen. Die ineinandergreifenden Profile sind vorzugsweise im seitlich gekoppelten Zustand formschlüssig miteinander verbunden.

Die Kupplungsvorrichtung kann in einer Ausführungsform ein axiales Fixierelement umfassen, welches zum Fixieren des ersten Teilgehäuses und des zweiten Teilgehäuses im axial gekoppelten Zustand der beiden Teilgehäuse ausgestaltet ist. Das axiale Fixierelement kann ein separates Bauteil sein, welches mit dem ersten Teilgehäuse und dem zweiten Teilgehäuse im axial gekoppelten Zustand der beiden Teilgehäuse verbindbar ist. Eine Längsrichtung des axialen Fixierelements kann sich hierbei in axialer Richtung erstrecken. Die axiale Richtung kann hierbei durch die Ausrichtung der Durchgangsöffnungen bzw. der Fluidleitungen definiert werden. Das axiale Fixierelement ist vorzugsweise im axial gekoppelten Zustand der beiden Teilgehäuse formschlüssig mit mindestens einem der Teilgehäuse oder mit beiden Teilgehäusen verbindbar.

In einer weiteren Ausbildung weist das axiale Fixierelement eine Seitenfläche auf, welche komplementär zur ersten Seitenfläche und zur zweiten Seitenfläche geformt ist. Die Seitenfläche des axialen Fixierelements kann außerdem im axial gekoppelten Zustand der beiden Teilgehäuse an den genannten Seitenflächen anliegen. Das axiale Fixierelement kann insbesondere mindestens einen Vorsprung und/oder mindestens einen Rücksprung und/oder mindestens ein Profil aufweisen, welche jeweils komplementär zum Rücksprung und/oder Vorsprung und/oder den Profilen der beiden Teilgehäuse geformt sind.

In einer Ausführung umfasst die Kupplungsvorrichtung ein Befestigungselement zum Befestigen der ersten Kupplungseinheit mit der zweiten Kupplungseinheit. Das Befestigungselement umfasst z.B. eine Schraube, welche mit einer in der ersten und/oder zweiten Kupplungseinheit befindlichen Mutter verschraubt werden kann. Eine Längsrichtung des Befestigungselements kann entlang der axialen Richtung ausgerichtet sein. Das Befestigungselement kann durch eine sich axial erstreckende Öffnung in der ersten und/oder zweiten Kupplungseinheit gesteckt werden. Durch das Befestigungselement kann das Einwirken einer Montagekraft bei dem Kupplungsvorgang z.B. entgegen den federgetriebenen Schnellverschlusseinheiten in dem Bereich des Kupplungssystems eingegrenzt werden. Damit kann verhindert werden, dass die Montagekraft in empfindliche Komponenten, wie eine Grafikkarte oder ein Mainboard (s. unten), eingeleitet wird.

In einer weiteren Variante umfasst die Kupplungsvorrichtung eine erste mit der ersten Durchgangsöffnung verbundene Fluidleitung und/oder eine zweite mit der zweiten Durchgangsöffnung verbundene Fluidleitung. Zur Verringerung von Torsionsspannungen können die genannten Fluidleitungen insbesondere drehbar mit den jeweiligen Durchgangsöffnungen verbunden sein. Die erste Fluidleitung und die zweite Fluidleitung können fluidisch mit einer Pumpe verbunden werden, wodurch sie eine Fluidrückleitung und eine Fluidzuleitung der Pumpe bilden können. Die Fluidleitungen können jeweils einen Schlauch oder mehrere Schläuche umfassen, die beispielsweise aus einem flexiblen Material gefertigt sind.

Die Kupplungsvorrichtung kann mindestens eine Erweiterungsleitung umfassen, wobei an einem ersten Ende der Erweiterungsleitung das erste Teilgehäuse befestigt ist und an einem zweiten Ende der Erweiterungsleitung das zweite Teilgehäuse befestigt ist. Durch die Erweiterungsleitung kann die Modularität des Systems weiter erhöht werden. In einer bevorzugten Ausführungsform sind zwei oder mehr Erweiterungsleitungen vorhanden. Die Kupplungsvorrichtung umfasst in diesem Fall zwei oder mehr erste Kupplungseinheiten. Die Erweiterungsleitung kann einen Schlauch aufweisen, der beispielsweise aus einem flexiblen Material gefertigt ist.

In einer Weiterbildung umfasst die Kupplungsvorrichtung eine zweite, mit der ersten Kupplungseinheit verbindbare Kupplungseinheit. Beispielsweise kann die erste Kupplungseinheit in ihrem seitlich gekoppelten Zustand mit der zweiten Kupplungseinheit verbindbar sein bzw. verbunden werden. Üblicherweise sind die erste Kupplungseinheit und die zweite Kupplungseinheit in axialer Richtung miteinander verbindbar.

Die zweite Kupplungseinheit kann eine dritte Stirnfläche aufweisen, welche komplementär zur ersten Stirnfläche und zur zweiten Stirnfläche geformt sein kann. Im verbundenen Zustand der ersten Kupplungseinheit und der zweiten Kupplungseinheit liegt die dritte Stirnfläche flächig an der ersten Stirnfläche und der zweiten Stirnfläche an. Die erste Kupplungseinheit und die zweite Kupplungseinheit können formschlüssig miteinander verbunden werden. Zur Vermeidung einer Fehlmontage können die erste Stirnfläche und/oder die zweite Stirnfläche und/oder die dritte Stirnfläche z.B. in Bezug auf die axiale Richtung der Durchgangsöffnungen abgeschrägt sein.

Die zweite Kupplungseinheit kann
- ein zweites Gehäuse mit einer dritten Durchgangsöffnung und einer vierten Durchgangsöffnung, und
- eine dritte Signalschnittstelle und eine vierte Signalschnittstelle aufweisen.

In einer Ausgestaltung sind die erste Kupplungseinheit und die zweite Kupplungseinheit ausgebildet:
i. im gekoppelten Zustand der beiden Kupplungseinheiten eine Fluidverbindung der ersten Durchgangsöffnung und der dritten Durchgangsöffnung sowie eine Fluidverbindung der zweiten Durchgangsöffnung und der vierten Durchgangsöffnung herzustellen.

Vorzugsweise sind die erste Kupplungseinheit und die zweite Kupplungseinheit außerdem ausgebildet
ii. eine Signalverbindung der ersten Signalschnittstelle mit der dritten Signalschnittstelle sowie eine Signalverbindung der zweiten Signalschnittstelle mit der vierten Signalschnittstelle herzustellen.

Unter einer Signalverbindung wird also eine Verbindung der Signalschnittstellen verstanden, bei der Signale über die Signalschnittstellen übertragen werden können.

Die Kupplungsvorrichtung kann derart ausgestaltet sein, dass beim Übergang vom entkoppelten Zustand zum gekoppelten Zustand der Kupplungseinheiten zunächst die Durchgangsöffnungen miteinander verbunden werden, und anschließend die Signalschnittstellen miteinander verbunden werden oder dass beim Übergang vom entkoppelten Zustand zum gekoppelten Zustand der Kupplungseinheiten die Durchgangsöffnungen miteinander verbunden werden und gleichzeitig die Signalschnittstellen miteinander verbunden werden. Beispielsweise kann die Verbindung der Signalschnittstellen erst dann hergestellt werden, wenn die Fluidverbindung fast vollständig oder vollständig hergestellt ist. Üblicherweise liegt im vollständig gekoppelten Zustand der geringste Strömungswiderstand der Fluidverbindung vor. In einer Ausführungsform wird die Verbindung der Signalschnittstellen erst dann hergestellt, wenn ein Strömungswiderstand der Fluidverbindung einen bestimmten Wert unterschritten hat. Hierdurch kann gewährleistet werden, dass eine Pumpe und/oder ein erster Wärmetauscher (s. unten) eines Fluidkühlsystems erst dann angesteuert wird, wenn sowohl die Fluidverbindung als auch die Verbindung der Signalschnittstellen hergestellt sind.

In einer weiteren Ausgestaltung ist an mindestens einer der Durchgangsöffnungen oder an jeder Durchgangsöffnung eine federgetriebene Verschlusseinheit vorgesehen, die die jeweilige Durchgangsöffnung in jedem Zustand der Kupplungsvorrichtung gegenüber der Umgebung abdichtet.

Das erste Teilgehäuse, das zweite Teilgehäuse und/oder das zweite Gehäuse können in einem Spritzgussverfahren aus spritzgegossenen Materialien, wie thermoplastischen oder duroplastischen Materialien, gefertigt sein. Denkbar wäre auch eine Fertigung dieser Bauteile in einem 3D-Druck-Verfahren. Außerdem können das erste Teilgehäuse, das zweite Teilgehäuse und/oder das zweite Gehäuse jeweils einstückig geformt sein.

Die Kupplungsvorrichtung kann mit einem Kühlkörper, wie mit dem Kühlkörper eines weiter unten beschriebenen zweiten Wärmetauschers, verbunden werden. Der Kühlkörper kann einen Fluideingang und einen Fluidausgang aufweisen, welche fluidisch mit den jeweiligen Durchgangsöffnungen der zweiten Kupplungseinheit verbindbar sind. Üblicherweise ist mindestens ein Befestigungsmittel zum Befestigen der zweiten Kupplungseinheit mit dem Wärmetauscher vorgesehen.

In einer Ausführungsform ist eine erste mit der ersten Signalschnittstelle und der zweiten Signalschnittstelle verbundene Kommunikationseinheit vorgesehen. Weiter kann eine zweite mit der dritten Signalschnittstelle und der vierten Signalschnittstelle verbundene Kommunikationseinheit vorgesehen sein. Im gekoppelten Zustand der Kupplungsvorrichtung sind die erste Kommunikationseinheit und die zweite Kommunikationseinheit miteinander verbindbar. Die Signalübertragung der Kommunikationseinheiten findet typischerweise erst statt, wenn die erste Kupplungseinheit und die zweite Kupplungseinheit vollständig gekuppelt sind. So wird sichergestellt, dass der Kühlkreislauf an der Kupplungsvorrichtung geschlossen ist und das Fluidkühlsystem nur dann in Betrieb genommen werden kann. Somit wird verhindert, dass es zu Undichtigkeiten kommen kann, die beispielsweise durch den Druckaufbau der Pumpe und aufgrund von halb geschlossenen Kupplungseinheiten hervorgerufen werden können. Mindestens eine der beiden Kommunikationseinheiten oder eine Steuereinheit kann ausgebildet sein, anhand eines Vorliegens der Verbindung der beiden Kommunikationseinheiten zu erkennen, ob die Kupplungsvorrichtung in einem gekoppelten oder entkoppelten Zustand ist.

Die erste Kommunikationseinheit und die zweite Kommunikationseinheit sind vorzugsweise über Signalleitungen miteinander verbunden. In einer weiteren Variante sind die erste, zweite, dritte und/oder vierte Signalschnittstellen jeweils mit Signalleitungen verbunden. Die Fluidleitungen und die Signalleitungen können zusammengeführt werden. Beispielsweise weist die erste Fluidleitung und/oder die zweite Fluidleitung eine Ausnehmung zum Führen der ersten Signalleitung bzw. der zweiten Signalleitung auf. Die Ausnehmung kann z.B. helixförmig oder gerade sein. Die Signalleitungen können die Fluidleitungen umgeben. In einer Ausführungsform sind die erste Kommunikationseinheit und die zweite Kommunikationseinheit ausgebildet, über elektrische oder optische Signale miteinander zu kommunizieren. Die Signalleitungen können z.B. optische Kabel, wie Glasfaserkabel, oder elektrische Kabel sein oder umfassen. Weiter können die Signale Daten, Sensorsignale, Steuerungssignale und/oder Regelungssignale umfassen. Je nach Ausführungsform sind die Signalschnittstellen elektrische oder optische Kontaktelemente. Falls notwendig können die optischen Signale in elektrische Signale konvertiert werden und andersherum. Etwaige analoge Signale können in digitale Signale konvertiert werden und andersherum. Weiter können die Signale verstärkt oder verarbeitet werden. Beispielsweise können ein opto-elektrischer Wandler, ein elektrooptischer Wandler, ein AD-Wandler, ein DA-Wandler, ein Signalverstärker und/oder eine Signalverarbeitungseinheit Bestandteile der ersten Kommunikationseinheit und/oder der zweiten Kommunikationseinheit sein.

Gemäß einem weiteren Aspekt wird ein Fluidkühlsystem bereitgestellt. Das Fluidkühlsystem umfasst z.B. einen ersten Wärmetauscher, einen zweiten Wärmetauscher, eine Pumpe, eine Steuereinheit zum Steuern der Pumpe, eine Fluidzuleitung, eine Fluidrückleitung und Signalleitungen. Weiter kann das Fluidkühlsystem die zuvor beschriebene die Kupplungsvorrichtung aufweisen.

Es kann vorgesehen sein, dass im gekoppelten Zustand der Kupplungsvorrichtung der erste Wärmetauscher und der zweite Wärmetauscher mittels der Fluidzuleitung und der Fluidrückleitung zum Bilden eines Fluidkreislaufs fluidisch miteinander verbunden sind. Die Steuereinheit kann ausgebildet sein, die Pumpe und/oder den ersten Wärmetauscher nur dann anzuschalten oder anzusteuern, wenn die Kupplungsvorrichtung im gekoppelten Zustand ist. Die Steuereinheit kann weiter ausgestaltet sein, die Pumpe und/oder den ersten Wärmetauscher abzuschalten, falls die Kupplungsvorrichtung im entkoppelten Zustand ist. Mindestens einer der beiden Wärmetauscher kann einen Lüfter aufweisen, der mit der Steuereinheit verbunden ist und durch diese steuerbar ist. Beispielsweise umfasst der erste Wärmetauscher einen der Steuereinheit verbundenen Lüfter, wobei der Lüfter durch die Steuereinheit angesteuert wird.

Die erste Kommunikationseinheit und die Steuereinheit können z.B. auf einer gemeinsamen ersten Elektroplatine angeordnet sein. Obwohl getrennt beschrieben, können die Steuereinheit und die erste Kommunikationseinheit Bestandteile einer einzigen Steuer- und Verarbeitungseinheit sein. Die zweite Kommunikationseinheit kann z.B. auf einer zweiten Elektroplatine angeordnet sein. Beispielsweise ist die zweite Elektroplatine auf einer Außenseite des genannten Kühlkörpers des zweiten Wärmetauschers angeordnet.

Die Kupplungsvorrichtung kann insbesondere dazu ausgelegt sein, ein erstes Modul und ein zweites Modul eines modularen Fluidkühlsystems miteinander zu verbinden (s. unten).

Gemäß einem weiteren Aspekt wird ein erstes Modul, insbesondere für ein Fluidkühlsystem, vorgeschlagen. Das erste Modul umfasst eine Steuereinheit, eine erste Kommunikationseinheit, eine Pumpe für ein Kühlfluid, und einen ersten Wärmetauscher.

Die erste Kommunikationseinheit ist ausgebildet zum Empfangen von Signalen von mindestens einem zweiten Modul, wobei die Signale ein Identifikationsmerkmal des zweiten Moduls aufweisen. Die Steuereinheit ist anhand des Identifikationsmerkmals ausgebildet zum
- Identifizieren des zweiten Moduls,
- Überprüfen, ob das zweite Modul systemkompatibel oder berechtigt ist, und
- Anschalten der Pumpe und/oder des ersten Wärmetauschers in Abhängigkeit eines Vorliegens des systemkompatiblen oder berechtigten zweiten Moduls.

Das genannte zweite Modul kann insbesondere das unten beschriebene zweite Modul sein. Das erste Modul kann z.B. als Master-Modul bezeichnet werden, während das zweite Modul als Slave-Modul bezeichnet werden kann. Falls also ein systeminkompatibles oder nicht berechtigtes zweites Modul detektiert wird, kann verhindert werden, dass die Pumpe und/oder der erste Wärmetauscher überhaupt angeschaltet werden. Hierdurch kann der Einsatz von systemkompatiblen Bauteilen und Komponenten in einem System mit modularer Bauweise sichergestellt werden.

Die Steuereinheit kann ausgebildet sein, anhand einer bestimmten Verschlüsselung und/oder Kodierung der Signale die Identität des zweiten Moduls festzustellen. Es kann vorgesehen sein, dass lediglich ein hierfür konzipierter Datenblock verschlüsselt oder kodiert ist. In diesem Fall ist also nur ein Teil des Signals verschlüsselt oder kodiert. Der unverschlüsselte Teil des Signals kann z.B. Daten, Sensorsignale, Steuerungssignale und/oder Regelungssignale umfassen. Es kann alternativ auch vorgesehen sein, dass das Signal insgesamt verschlüsselt ist. In diesem Fall können z.B. sämtliche Daten, Sensorsignale, Steuerungssignale und/oder Regelungssignale verschlüsselt oder kodiert sein. Das erste Modul und das zweite Modul können jeweils eine hierfür ausgelegte Entschlüsselungsvorrichtung/Dekodierungsvorrichtung bzw. Verschlüsselungsvorrichtung/Kodierungsvorrichtung aufweisen. Das Signal kann eventuell auch auf Vollständigkeit abgeglichen werden, z.B. mittels einer Prüfziffer oder dergleichen.

Alternativ oder zusätzlich kann das Identifikationsmerkmal eine Seriennummer des zweiten Moduls umfassen. In diesem Fall kann die Steuereinheit anhand der Seriennummer des zweiten Moduls die Identität des zweiten Moduls feststellen. Vorzugsweise kann mit dem Identifikationsmerkmal die Identität des zweiten Moduls eindeutig bestimmt werden. Die Steuereinheit kann weiter ausgebildet sein, die Pumpe und/oder den ersten Wärmetauscher in Abhängigkeit der Identität des zweiten Moduls anzusteuern. Die Signale können des Weiteren Kühlparameter umfassen, wobei die Steuereinheit ausgebildet ist, die Pumpe und/oder den ersten Wärmetauscher in Abhängigkeit der Kühlparameter anzusteuern. Der erste Wärmetauscher kann einen Lüfter und einen Radiator aufweisen, wobei der Lüfter vorzugsweise zum Kühlen des Radiators an dem Radiator angeordnet ist. Hierdurch kann die Kühlwirkung des ersten Wärmetauschers gesteigert bzw. gesteuert oder geregelt werden. Die Pumpe kann fluidisch mit dem Radiator verbunden sein und somit das Kühlfluid durch den Radiator pumpen.

Die Leistung der Pumpe und des Lüfters können je nach Bedarf durch die Steuereinheit des ersten Moduls variabel gesteuert werden. Die Steuereinheit des ersten Moduls kann ausgebildet sein, bei konstanter Pumpenleistung den Lüfter variabel zu steuern. Weiter kann die Steuereinheit des ersten Moduls ausgebildet sein, bei konstanter Lüfterleistung die Pumpe variabel zu steuern.

Die Steuereinheit des ersten Moduls kann einen Prozessor, einen Mikrocontroller, einen Mikroprozessor und/oder einen digitalen Signalprozessor aufweisen. Weiter kann das erste Modul einen Speicher, wie z.B. random access memory (RAM), read only memory (ROM), eine Festplatte, ein magnetisches Speichermedium und/oder ein optisches Laufwerk aufweisen. In dem Speicher kann ein Identifizierungscode oder eine Identifizierungsnummer gespeichert sein, z.B. ein UUID (Universally Unique Identifier), der oder die dem ersten Modul zugeordnet ist. Der Identifizierungscode oder die Identifizierungsnummer kann bei einer Vielzahl von ersten Modulen (s. unten) für jedes dieser ersten Module einzigartig sein, d.h. verschiedene erste Module haben verschiedene Identifizierungscodes oder Identifizierungsnummern. Im Speicher kann ein Programm gespeichert sein, z.B. eine Software zur Verarbeitung oder Bearbeitung der Daten und/oder der Signale und/oder eine Software zur Steuerung der Pumpe und/oder des Lüfters.

Gemäß einem weiteren Aspekt wird ein zweites Modul, insbesondere für ein Fluidkühlsystem, bereitgestellt. Das zweite Modul umfasst zumindest eine zweite Kommunikationseinheit. Die zweite Kommunikationseinheit ist ausgebildet zum Senden eines Identifikationsmerkmals des zweiten Moduls an eine erste Kommunikationseinheit eines ersten Moduls.

Das erste Modul kann hierbei insbesondere das oben beschriebene erste Modul sein. Das Identifikationsmerkmal kann eine Seriennummer, eine bestimmte Verschlüsselung oder eine bestimmte Kodierung von Signalen sein oder umfassen.

Das zweite Modul kann außerdem einen zweiten Wärmetauscher aufweisen, welcher mit einer zu kühlenden Einheit verbindbar ist. Die zweite Kommunikationseinheit kann ausgebildet sein, Signale zu empfangen und an die erste Kommunikationseinheit weiterzuleiten. So kann die zweite Kommunikationseinheit ausgebildet sein, Kühlparameter der zu kühlenden Einheit zu empfangen und die genannten Kühlparameter an die erste Kommunikationseinheit zu senden. Hierbei können die Kühlparameter Sensorsignale und/oder Sensordaten und/oder Temperaturdaten und/oder Energieverbrauchsdaten und/oder Pumpenparameter und/oder Wärmetauscherparameter und/oder Steuerungssignale und/oder Regelungssignale umfassen.

Typischerweise ist die zu kühlende Einheit eine Steuer- und Verarbeitungseinheit, wie eine CPU (central processing unit) oder eine GPU (graphics processing unit). Eine derartige Steuer- und Verarbeitungseinheit kann in der Regel ausgeben, wie hoch seine momentane Taktgeschwindigkeit, Temperatur oder Leistung ist. Basierend auf diesen Kühlparametern kann dann die Pumpe oder der Lüfter des ersten Moduls angesteuert werden. Weiter gibt die Steuer- und Verarbeitungseinheit in der Regel eine Lüfter-Drehzahl aus, welche für die Steuerung des Lüfters verwendet werden kann.

Weiter kann das zweite Modul einen Speicher, wie z.B. random access memory (RAM), read only memory (ROM), eine Festplatte, ein magnetisches Speichermedium und/oder ein optisches Laufwerk aufweisen. In dem Speicher kann ein Identifizierungscode oder eine Identifizierungsnummer gespeichert sein, z.B. ein UUID, der oder die dem zweiten Modul zugeordnet ist. Der Identifizierungscode oder die Identifizierungsnummer kann bei einer Vielzahl von zweiten Modulen (s. unten) für jedes dieser zweiten Module einzigartig sein, d.h. verschiedene zweite Module haben verschiedene Identifizierungscodes oder Identifizierungsnummern. Nach dem Aufbau der Verbindung zwischen der ersten Kommunikationseinheit und der zweiten Kommunikationseinheit kann der Identifizierungscode oder die Identifizierungsnummer an die erste Kommunikationseinheit des ersten Moduls übermittelt werden.

Gemäß einem weiteren Aspekt wird ein Fluidkühlsystem vorgeschlagen, welches das zuvor beschriebene erste Modul und das zuvor beschriebene zweite Modul aufweist. Außerdem umfasst das Fluidkühlsystem Kühlleitungen, Signalleitungen und eine Kupplungsvorrichtung zum Verbinden des ersten Moduls mit dem zweiten Modul. Die Kupplungsvorrichtung ist ausgestaltet, durch Kupplung der Kühlfluidleitungen den ersten Wärmetauscher und den zweiten Wärmetauscher fluidisch miteinander zu verbinden und durch Kupplung der Signalleitungen die erste Kommunikationseinheit und die zweite Kommunikationseinheit miteinander zu verbinden.

Die Kupplungsvorrichtung kann hierbei insbesondere die Kupplungsvorrichtung der zuvor beschriebenen Art sein. Das im Zusammenhang mit den ersten und zweiten Modulen beschriebene Kühlfluidsystem kann somit die Merkmale des im Zusammenhang mit der Kupplungsvorrichtung beschriebenen Kühlfluidsystems aufweisen und andersherum.

Durch die Modularität kann das Kühlfluidsystem beliebig erweitert werden. So kann das Kühlfluidsystem eine Vielzahl erster Module und/oder eine Vielzahl zweiter Module aufweisen, wobei die Fluidleitungen und die Signalleitungen seriell miteinander verbindbar oder verbunden sind. Weiter kann das Kühlfluidsystem eine Vielzahl von Kupplungsvorrichtungen aufweisen, mittels derer die Module untereinander verbunden werden können.

Falls mehrere zweite Module vorhanden sind, ist es vorteilhaft, die Pumpe und/oder den ersten Wärmetauscher des ersten Moduls (bzw. der ersten Module) gemäß einem vorbestimmten Protokoll anzusteuern. Die Vielzahl zweiter Module kann z.B. Kühlparameter an die erste Kommunikationseinheit senden. Die Steuereinheit des ersten Moduls ist z.B. ausgebildet zum
- Auswerten und/oder Vergleichen der Kühlparameter der zweiten Module,
- Steuern der Pumpe und/oder des ersten Wärmetauschers basierend auf der Auswertung und/oder dem Vergleich.

Es kann vorgesehen sein, dass die Pumpe basierend auf einem einzigen Kühlparameter angesteuert wird. Denkbar wäre z.B., dass die Pumpe basierend auf einem Kühlparameter eines einzigen zweiten Moduls eine Vielzahl von zweiten Modulen angesteuert werden. Der entsprechende Kühlparameter wird in der Regel über die entsprechenden Kommunikationseinheiten durch jedes zweite Modul an das erste Modul übermittelt. Die Steuereinheit des ersten Moduls vergleicht die Kühlparameter miteinander und entscheidet dann basierend auf dem Vergleich, wie die Pumpe angesteuert wird. Wenn z.B. Temperaturdaten als Kühlparameter an die erste Steuereinheit übermittelt werden, kann die erste Steuereinheit die Pumpe basierend auf der höchsten Temperatur ansteuern. Entsprechendes kann für die Steuerung des ersten Wärmetauschers bzw. des Lüfters gelten.

Falls mehrere erste Module vorhanden sind, ist es vorteilhaft, wenn sich die ersten Module untereinander absprechen. So sollte vorab geklärt werden, welche Steuereinheit die Steuerung des Gesamtsystems übernimmt. Es kann z.B. vorgesehen sein, dass jedes erste Modul eine Seriennummer aufweist, wobei die Seriennummer nach Herstellungsdatum des ersten Moduls vergeben werden kann. Das erste Modul mit der höchsten Seriennummer kann dann die Steuerung der Pumpen bzw. der Lüfter des Gesamtsystems übernehmen. Weiter können auch die Kühldaten des zweiten Moduls für die Steuerung der Pumpen oder Lüfter verwendet werden, welches die höchste Seriennummer hat. Falls mehrere erste Module vorgesehen sind, können die Steuerungen der Pumpen oder der Lüfter aufeinander abgestimmt werden. Falls beispielsweise die Lautstärke des Gesamtsystems verringert werden soll, kann die Leistung von besonders lauten Pumpen (oder Lüftern) herunter geregelt werden, während die Leistung von besonders leisen Pumpen (oder Lüftern) gesteigert werden kann. Die Steuereinheiten der ersten Module können ausgebildet sein, ihre Pumpen derart anzusteuern, dass ein Fluiddurchsatz ihrer jeweiligen Pumpen gleich ist.

In einer Ausführungsform sind die Signalleitungen als Eindraht-Bussystem ausgestaltet. Hierdurch kann das System vereinfacht werden.

Gemäß einem weiteren Aspekt wird ein Verfahren bereitgestellt. Das Verfahren eignet sich insbesondere zum Betreiben eines Fluidsystems. Das Verfahren umfasst zumindest die folgenden Schritte:
- Empfangen von Signalen, wobei die Signale ein Identifikationsmerkmal eines zweiten Moduls aufweisen,
- Identifizieren des zweiten Moduls anhand des Identifikationsmerkmals,
- Überprüfen, ob das zweite Modul systemkompatibel oder berechtigt ist, und
- Anschalten einer Pumpe und/oder eines ersten Wärmetauschers in Abhängigkeit eines Vorliegens des systemkompatiblen oder berechtigten zweiten Moduls.

Falls kein zweites Modul identifiziert werden kann, wird festgestellt, dass die Signale von einem systeminkompatiblen oder nicht-berechtigten Modul stammen. Die Pumpe oder der erste Wärmetauscher werden in diesem Fall nicht angeschaltet.

Falls das zweite Modul systemkompatibel oder berechtigt ist, können die Pumpe und/oder der zweite Wärmetauscher in Abhängigkeit der Identität des zweiten Moduls angesteuert werden.

Das Verfahren kann insbesondere eins oder mehrere Merkmale sowie einen oder mehrere Schritte aufweisen, die oben bei der Erläuterung der Module und/oder des Kühlfluidsystems und/oder der Kupplungsvorrichtung beschrieben wurden. Das Verfahren kann z.B. als Code implementiert sein, beispielsweise in der Form eines Computerprogramms auf einem Computer-lesbaren Medium, wie einem volatilen Speicher oder einem nicht-volatilen Speicher.

Insgesamt ergibt sich durch die Modularität der Kupplungsvorrichtung bzw. des Fluidkühlsystems eine Reihe von Vorteilen gegenüber einteiligen Kupplungsvorrichtungen bzw. nicht-erweiterbarer Fluidkühlsysteme aus dem Stand der Technik:
- Erweiterung des Fluidkühlsystems um weitere Module;
- Flexibilität im Angebot, größere Produktvarietät;
- billigere Herstellung durch baugleiche Serien und einfachere Montageprozesse; und/oder
- kostengünstige Reparatur durch Austausch der fehlerhaften Komponente.

Weiter können Kosten und Aufwand für Konstruktion, Fertigung, Lagerung, Vertrieb, Instandhaltung und Reparatur durch den modularen Aufbau der Kupplungsvorrichtung oder des Fluidkühlsystems gesenkt werden.

Der Einsatz des zuvor beschriebenen modularen Fluidkühlsystems in Desktop PCs und anderen Elektroniksystemen kann einige Vorteile gegenüber herkömmlichen Luftkühlsystemen oder gekapselten Fluidkühlsystemen bieten. So kann der erste Wärmetauscher, der die Wärme an die Umgebungsluft überträgt, baulich weiter entfernt von der Wärmequelle positioniert werden. Durch die räumliche Trennung des vorgeschlagenen modularen Fluidkühlsystems können Bauraum- und Gewichtseinschränkungen umgangen werden. Somit können Radiatoren mit einer größeren Oberfläche verwendet und die Kühlleistung gesteigert werden.

Durch die Signalübertragung der Kommunikationseinheiten lassen sich die folgenden Funktionen realisieren:
- Überprüfung der einwandfreien Montage;
- Sicherstellung des Einsatzes systemkompatibler Komponenten und Bauteile;
- Übertragung von Signalen für Steuerungs- und Regelungsfunktionen.

Im Gegensatz zu einer Lösung mit getrennt verlegten Signalleitungen, kann bei korrekt gekuppelten Kupplungen immer eine Signalübertragung gewährleistet werden und eine Fehlfunktion aufgrund von falsch angeschlossenen Signalleitungen kann verhindert werden.

Es versteht sich, dass die oben beschriebenen Ausführungsformen miteinander kombiniert werden können, sofern sich die Kombinationen nicht gegenseitig ausschließen. Merkmale, die nur in Bezug auf die oben beschriebene Kupplungsvorrichtung genannt wurden, können auch für das erste Modul, das zweite Modul, das Fluidkühlsystem oder das Verfahren beansprucht werden und andersherum.

Im Folgenden werden Ausführungsformen der Erfindung anhand beigefügter Zeichnungen näher erläutert. Hierbei sind die Figuren schematisiert und teilweise vereinfacht. Es zeigen:
- Fig. 1: eine Ansicht eines modularen Kühlfluidsystems mit einem ersten Modul, einem zweiten Modul und einer Kupplungsvorrichtung;
- Fig. 2: eine Ansicht des Kühlfluidsystems der Fig. 1, wobei die Module voneinander getrennt sind;
- Fig. 3: eine Explosionszeichnung des Kühlsystems der Fig. 1;
- Fig. 4: eine Explosionszeichnung einer Kupplungsvorrichtung;
- Fig. 5: weitere Ansichten der Kupplungsvorrichtung der Fig. 4;
- Fig. 6: ein modulares Kühlfluidsystem mit mehreren ersten Modulen, zweiten Modulen und Kupplungsvorrichtungen; und
- Fig. 7: eine Schematische Darstellung eines Fluidkühlsystems mit einem ersten Modul, einem zweiten Modul und einer Kupplungsvorrichtung.

In den Figuren sind wiederkehrende Merkmale mit denselben Bezugszeichen versehen.

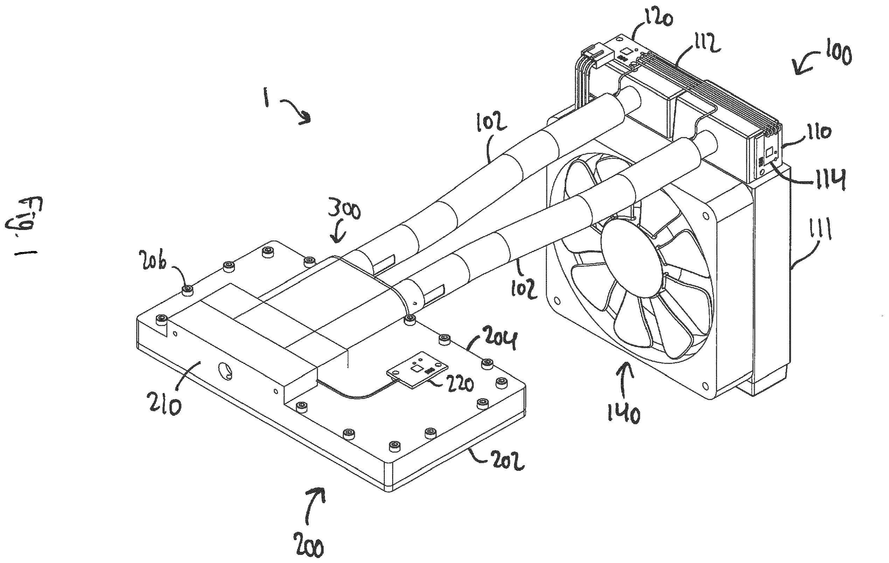

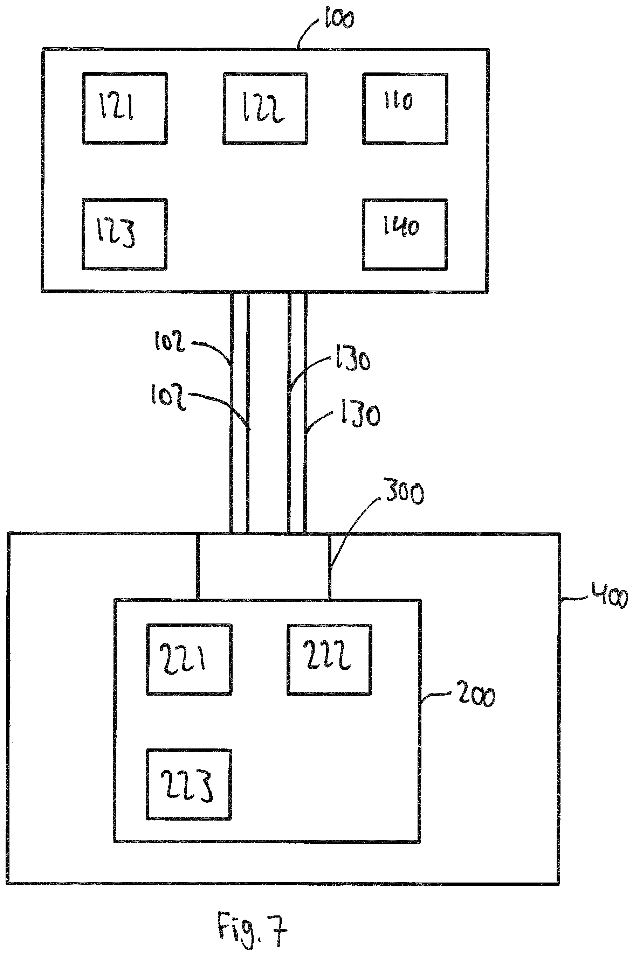

Die Fig. 1 zeigt eine perspektivische Ansicht eines Fluidkühlsystems 1, während die Fig. 7 eine schematische Darstellung des Fluidkühlsystems 1 ist. Das Fluidkühlsystem 1 umfasst zwei Wärmetauscher die über Fluidleitungen 102, eine Kupplungsvorrichtung 300 und eine Pumpe 110 fluidisch miteinander verbunden sind. Am zweiten Wärmetauscher kann z.B. die Verlustwärme von elektronischen Bauteilen, wie einer Grafikkarte 400, an eine Kühlflüssigkeit übertragen werden. Die Pumpe 110 fördert die erwärmte Kühlflüssigkeit durch die Leitungen 102 zum ersten Wärmetauscher. Der erste Wärmetauscher umfasst z.B. einen Radiator 111, der von der erwärmten Kühlflüssigkeit durchströmt wird. Hier wird die Wärme der Kühlflüssigkeit über eine Radiatorwand an die Umgebungsluft abgegeben. Diese Wärmeübertragung kann durch den Luftstrom eines Lüfters 140 verbessert werden.

Das Fluidkühlsystem 1 umfasst zwei Teilsysteme 100, 200, die mit miteinander über Fluidleitungen, Signalleitungen und die Kupplungsvorrichtung 300 gekoppelt sind (Fig. 1). Im Folgenden werden die Teilsysteme als erstes Modul 100 bzw. zweites Modul 200 bezeichnet. Durch das Zusammenführen des ersten Moduls 100 und des zweiten Moduls 200 über die Kupplungsvorrichtung 300 entsteht das Fluidkühlsystem 1 mit einem geschlossenen Kühlkreislauf und einem geschlossenen Signalkreislauf (Signalkreis). Das Fluidkühlsystem 1 kann in unterschiedlichen Bereichen eingesetzt werden. Das Fluidkühlsystem 1 kann insbesondere verwendet werden, um Computer-Komponenten, wie eine CPU oder eine GPU zu kühlen. Dementsprechend kann das Kühlfluidsystem 1 beispielsweise an einer Grafikkarte 400 (s. Fig. 7) oder an einer Hochleistungselektroplatine angeordnet werden. Das Kühlfluid des Fluidkühlsystems 1 ist vorzugsweise eine Flüssigkeit, wie Wasser oder destilliertes Wasser. Es können auch andere Kühlflüssigkeiten oder Flüssigkeitsgemische verwendet werden.

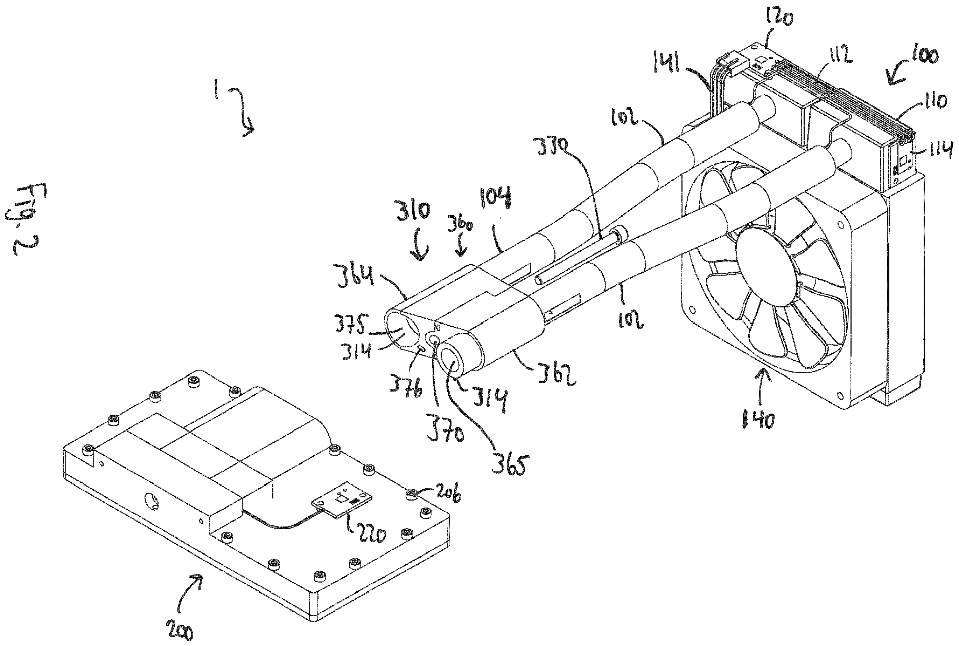

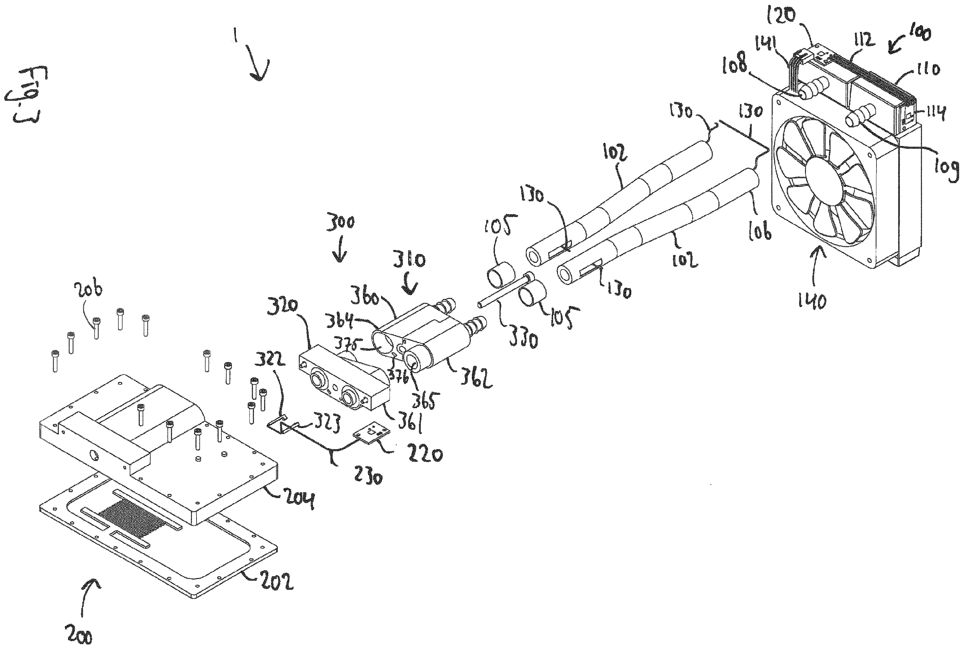

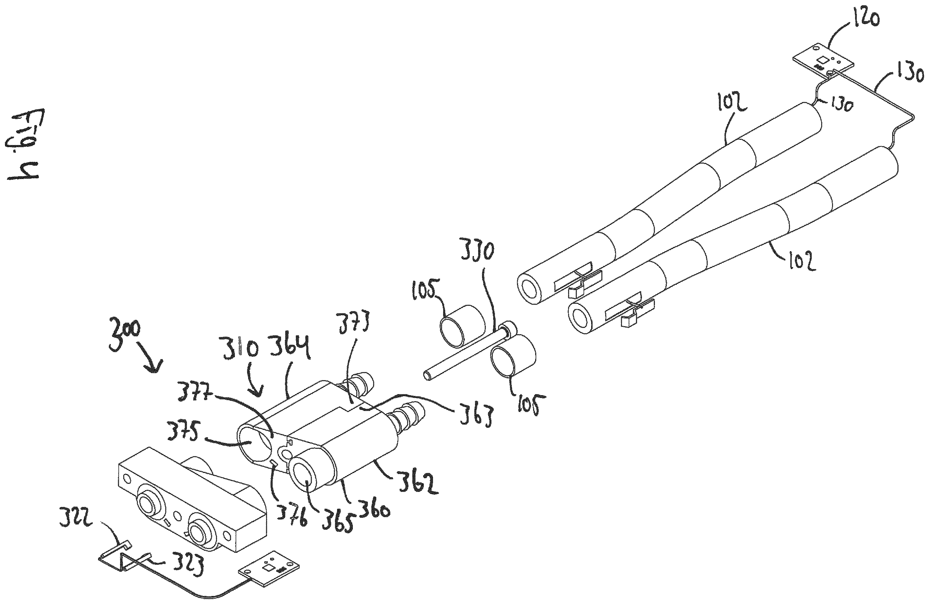

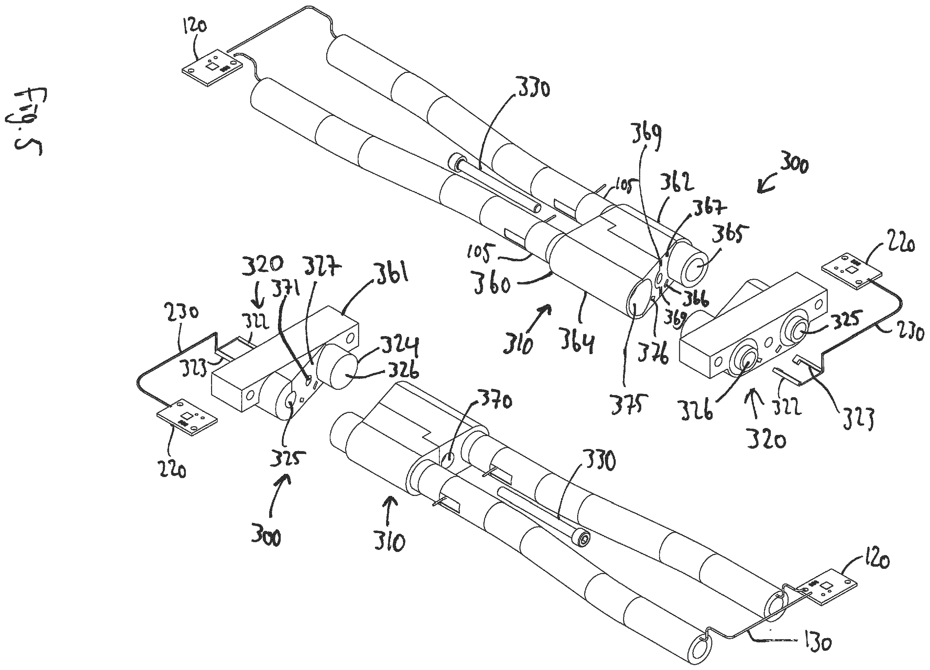

Zunächst wird näher auf die Kupplungsvorrichtung 300 eingegangen, welche außerdem in den Figuren 2-5 gut erkennbar ist. Die Kupplungsvorrichtung 300 umfasst eine erste Kupplungseinheit 310 mit einem ersten Gehäuse 360, welches ein erstes Teilgehäuse 362 und ein zweites mit dem ersten Teilgehäuse 362 verbindbares Teilgehäuse 364 aufweist. Die beiden Teilgehäuse 362, 364 sind jeweils einstückig und können insbesondere aus thermoplastischen Materialien gefertigt sein. Alternativ können eines der Teilgehäuse 362, 364 oder beide Teilgehäuse 362, 364 auch mehrteilig und zusammengesetzt sein.

Das erste Teilgehäuse 362 weist eine sich in axialer Richtung erstreckende erste Durchgangsöffnung 365, eine erste Signalschnittstelle 366 und eine erste Stirnfläche 367 auf. In ähnlicher Weise umfasst das zweite Teilgehäuse 364 eine sich in axialer Richtung erstreckende zweite Durchgangsöffnung 375, eine zweite Signalschnittstelle 376 und eine zweite Stirnfläche 377 auf.

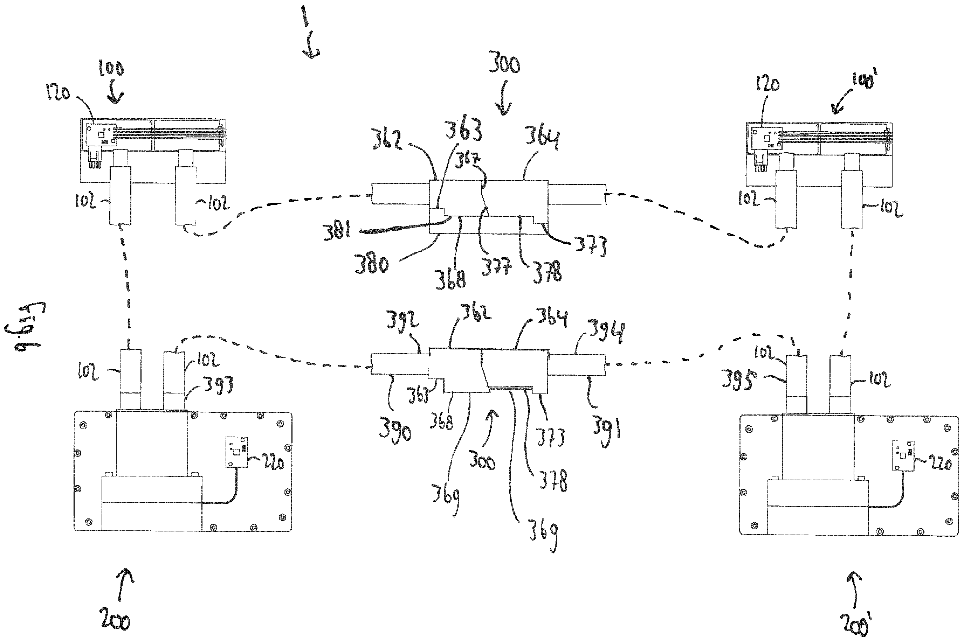

In den Figuren 1-5 sind die beiden Teilgehäuse 362, 364 parallel nebeneinander angeordnet und seitlich miteinander verbunden. Die beiden Teilgehäuse 362, 364 haben Seitenflächen 368, 378 (angedeutet in der Fig. 6), die im gekoppelten Zustand des ersten Gehäuses 360 aneinander anliegen. Die Seitenflächen 368, 378 sind vorzugsweise komplementär geformt, sodass die beiden Teilgehäuse 362, 364 seitlich miteinander verbunden werden können. Beispielsweise weist das zweite Teilgehäuse 364 einen Vorsprung 373 auf, der in einen Rücksprung 363 des ersten Teilgehäuses 362 eingreift. Der Vorsprung 373 wirkt als axialer Stopp und kann eine Verschiebung des ersten Teilgehäuses 362 in Bezug auf das zweite Teilgehäuse 364 in Richtung des ersten Moduls 100 verhindern. Außerdem können die beiden Teilgehäuse 362, 364 ineinandergreifende Profile 369, wie T-Profile, aufweisen, welche sich in axialer Richtung erstrecken und eine laterale Fixierung der beiden Teilgehäuse 362, 364 relativ zueinander ermöglichen. Die beiden Teilgehäuse 362, 364 sind also formschlüssig miteinander verbunden.

Weiter sind an den Durchgangsöffnungen 365, 375 zwei federgetriebene Schnellverschlusseinheiten 314 vorgesehen, die das Eindringen von Gasen und das Auslaufen von Flüssigkeiten verhindern. Die Schnellverschlusseinheiten 314 können z.B. Sicherheitsventile aufweisen. In die erste Kupplungseinheit 310 können zwei identische Fluidleitungen 102, wie Schläuche, eingesteckt werden. Das jeweilige Kupplungsseitige Schlauchende 104 kann jeweils mit einer Radialdichtung versehen sein, um das Auslaufen und das Entweichen von Gasen und Flüssigkeiten zu verhindern. Die Struktur der Fluidleitung 102 kann derart gestaltet sein, dass mindestens eine Signalleitung 130, wie ein elektrisches Kabel, um die Fluidleitung 102 gewickelt oder entlang der Fluidleitung 102 geführt werden kann. Jede Fluidleitung 102 kann hierbei mit einer Signalleitung 130 versehen sein. Die Fluidleitung 102 kann als flexible, elastische Leitung ausgestaltet sein, und z.B. im Wesentlichen aus einem Kunststoff, wie einem Elastomer oder thermoplastischen Materialien, gefertigt sein. Die Fluidleitung 102 kann auch ein starres Rohr aus einem Hartplastik umfassen. Eine Ummantelung, wie ein Gewebeschlauch, kann vorgesehen sein, welche die Fluidleitung 102 zumindest bereichsweise umhüllt. Die Ummantelung kann z.B. an einem Ende oder an beiden Enden der Fluidleitung 102 vorgesehen sein. Die Ummantelung kann sich auch von einem Ende bis zum gegenüberliegenden Ende der Fluidleitung 102 erstrecken und die Fluidleitung 102 vollständig bedecken, sodass die Fluidleitung 102 nicht sichtbar ist. Anstelle der Fluidleitung 102 kann auch die Ummantelung die Signalleitungen 130 enthalten. Die Ummantelung kann die Fluidleitung 102 stabilisieren und/oder auch als dekoratives Element fungieren.

Die Signalschnittstellen 366, 376 sind im gezeigten Ausführungsbeispiel als elektrisch leitende, z.B. metallische, Kontaktelemente ausgebildet. Dementsprechend sind die Signalleitungen 130 als elektrisch leitende Kabel ausgeführt. Um das kupplungsvorrichtungsseitige Schlauchende 104 ist ein elektrisch leitender, z.B. ein metallischer, Abnehmerring 105 formgepresst. Durch die Formgebung hat der metallische Abnehmerring 105 einen elektrischen Kontakt mit dem elektrischen Kabel 130 und dem jeweiligen metallischen Kontaktelement 366, 376. Durch den Abnehmerring 105 kann eine Drehbarkeit der Signalleitungen 130 in Bezug auf die Signalschnittstellen 366, 376 ohne Torsionsspannung realisiert werden. Der umgeformte metallische Abnehmerring hat zudem die Funktion, den Gewebeschlauch der Fluidleitung 102 zu fixieren. Alternativ können auch optische Kontaktelemente für die Übertragung von optischen Signalen vorgesehen sein. In diesem Fall sind die Signalleitungen 130 und Signalschnittstellen 366, 376 als Glasfaserkabel bzw. optisch leitende Elemente ausgestaltet.

In der Fig. 6 ist die Kupplungsvorrichtung 300 in einem axial gekoppelten Zustand gezeigt. Zu erkennen ist, dass die erste Stirnfläche 367 und die zweite Stirnfläche 368 komplementär zueinander geformt sind, wodurch eine axiale Kupplung des ersten Teilgehäuses 362 mit dem zweiten Teilgehäuse 364 ermöglicht wird. Die beiden Teilgehäuse 362, 364 sind in der Fig. 6 also axial nacheinander angeordnet. Im axial gekoppelten Zustand sind die Durchgangsöffnungen 365, 375 fluidisch miteinander verbunden und die Signalschnittstellen 366, 376 sind ebenfalls miteinander verbunden. In der Fig. 6 ist außerdem ein axiales Fixierelement 380 gezeigt, welches zum Fixieren des ersten Teilgehäuses 362 und des zweiten Teilgehäuses 364 im axial gekoppelten Zustand der beiden Teilgehäuse 363, 364 ausgestaltet ist. Hierzu weist das axiale Fixierelement insbesondere eine Seitenfläche 381 auf, welche komplementär zur ersten Seitenfläche 368 und zur zweiten Seitenfläche 378 geformt ist. Die Seitenfläche 381 des axialen Fixierelements 380 liegt an den Seitenflächen 368, 378 an. Dementsprechend hat auch das axiale Fixierelement einen Vorsprung, einen Rücksprung und ein Profil, welche mit den korrespondierenden Elementen 363, 367, 373 der Teilgehäuse 362, 364 zusammenwirken.

Die Kupplungsvorrichtung 300 umfasst außerdem eine zweite mit der ersten Kupplungseinheit 310 verbindbare Kupplungseinheit 320. Die zweite Kupplungseinheit 320 ist mit der ersten Kupplungseinheit 310 in axialer Richtung verbindbar, vorausgesetzt dass die erste Kupplungseinheit 310 in ihrem seitlich verbundenen Zustand ist. Die zweite Kupplungseinheit 320 kann hierzu ein zweites Gehäuse 361 mit einer dritten Stirnfläche 327 aufweisen, die komplementär zur ersten Stirnfläche 367 und zur zweiten Stirnfläche 377 geformt ist. Das zweite Gehäuse 361 ist einstückig geformt und kann aus einem thermoplastischen Material gefertigt sein. Im Gehäuse 361 sind eine dritte Durchgangsöffnung 325 und eine vierte Durchgangsöffnung 326 vorgesehen, welche jeweils mit der ersten Durchgangsöffnung 365 und der zweiten Durchgangsöffnung 375 fluidisch verbunden werden können. In der zweiten Kupplungseinheit 320 befinden sich vorzugsweise zwei federgetriebene Schnellverschlusseinheiten 324, die das Eindringen oder Entweichen von Gasen und das Auslaufen von Flüssigkeiten verhindern. Die Schnellverschlusseinheiten 324 können beispielsweise Sicherheitsventile aufweisen. Außerdem sind Signalschnittstellen 322, 323 vorgesehen, welche zur Signalübertragung mit den Signalschnittstellen 366, 376 der ersten Kupplungseinheit 310 verbunden werden können.

Somit sind im gekoppelten Zustand der beiden Kupplungseinheiten 310, 320 sowohl eine Fluidverbindung (über die entsprechenden Durchgangsöffnungen 325, 326, 365, 375) als auch eine Signalverbindung (über die entsprechenden Signalschnittstellen 322, 323, 366, 367) hergestellt.

Optional kann im ersten Teilgehäuse 362 eine sich in axialer Richtung erstreckende Durchgangsöffnung 370 vorgesehen sein, in welche eine Schraube 330 eingesteckt werden kann. Die Durchgangsöffnung 370 kann zusätzlich oder alternativ auch im zweiten Teilgehäuse 364 vorgesehen sein. Die Durchgangsöffnung 370 fluchtet im verbundenen Zustand der Kupplungseinheiten 310, 320 mit einer weiteren Öffnung 371, welche ein Innengewinde aufweist. Alternativ kann in der Öffnung 371 auch eine Langmutter angeordnet sein. Beim Verbinden der beiden Kupplungseinheiten 310, 320 wird die Schraube 330 durch die Öffnungen 370, 371 gesteckt und mit dem Gewinde der Öffnung 371 oder der Langmutter verschraubt.

Die Stirnflächen 327, 367, 377 sind in Bezug auf die axiale Richtung abgeschrägt. Durch die abgeschrägte Bauform der Stirnflächen 327, 367, 377 kann eine falsche Montage der Kupplungseinheiten 310, 320 verhindert werden. Hierdurch kann sichergestellt werden, dass die Fluidleitungen und die Signalleitungen richtig miteinander verbunden werden (Vermeidung von Kurzschlüssen).

Das Koppeln des ersten Moduls 100 und des zweiten Moduls 200 erfolgt über das Zusammenfügen der ersten Kupplungseinheit 310 und der zweiten Kupplungseinheit 320. Die zweite Kupplungseinheit 320 ist vor dem Kuppeln mit der ersten Kupplungseinheit 310 in der Regel fest mit dem zweiten Modul 200 verbunden. Für den Zusammenbau der Kupplungseinheiten 310, 320 wird beispielsweise die Schraube 330 verwendet, um das Einwirken der Montagekraft bei dem Kupplungsvorgang - entgegen der federgetriebenen Schnellverschlusseinheiten der Kupplungseinheiten 310, 320 - in dem Bereich des Kupplungssystems einzugrenzen. Durch diese Kraftentkopplung wird verhindert, dass die Montagekraft weder in die Grafikkarte 400 (s. Fig. 7) noch in ein Mainboard (Anwendungsbeispiel: Personal Computer) eingeleitet wird. Die erste Kupplungseinheit 310 und die zweite Kupplungseinheit 320 werden somit mit der Schraube 330 relativ zueinander fixiert.

Nachfolgend wird näher auf die Einzelheiten der Module 100, 200 eingegangen, wobei ergänzend auf die Fig. 7 Bezug genommen wird. In der Fig. 7 sind schematisch zwei Module 100, 200, eine Kupplungsvorrichtung 300 und eine Grafikkarte 400 angedeutet.

Das erste Modul 100 umfasst eine Steuereinheit 121, eine erste Kommunikationseinheit 122 und einen Speicher 123, welche beispielsweise gemeinsam auf einer ersten Elektroplatine 120 angeordnet sind. Das erste Modul 100 weist weiter eine Pumpe 110 zur Förderung des Kühlfluids und einen ersten Wärmetauscher mit einem Radiator 111 auf. Zur Verbesserung der Wärmeabfuhr ist der Radiator 111 mit einem Lüfter 140 versehen (s. auch Fig. 1). Es sind zwei Anschlussnippel 108, 109 vorgesehen, über die die Fluidleitungen 102 an die Pumpe 110 und den damit verbundenen Wärmetauscher angeschlossen werden können. Die mit den Fluidleitungen 102 geführten elektrischen Kabel 130 sind mit der ersten Steuereinheit 121 verbunden. Die erste Steuereinheit 121 kontrolliert und steuert über einen elektrischen Kabelverbund 141 einen Lüfter 140. Von der ersten Steuereinheit 121 geht ein elektrischer Kabelverbund 112 an eine Elektroplatine 114 der Pumpe 110. Die erste Steuereinheit 121 kontrolliert und steuert somit ebenfalls die Pumpe 110. In dem Speicher 123 kann ein Identifizierungscode oder eine Identifizierungsnummer gespeichert sein, z.B. ein UUID, der oder die dem ersten Modul 100 zugeordnet ist. Der Identifizierungscode oder die Identifizierungsnummer kann bei einer Vielzahl von ersten Modulen 100, 100' (s. unten) für jedes dieser ersten Module 100, 100' einzigartig sein, d.h. verschiedene erste Module 100, 100' haben verschiedene Identifizierungscodes oder Identifizierungsnummern. Im Speicher 123 kann ein Programm gespeichert sein, z.B. eine Software zur Verarbeitung oder Bearbeitung der Daten und/oder der Signale und/oder eine Software zur Steuerung der Pumpe 110 und/oder des Lüfters 140.

Das zweite Modul 200 hat einen Wärmetauscher, der einen Kühlkörper 210 mit einer Kühlkörperunterschale 202 und einer Kühlkörperoberschale 204 aufweist. Zwischen der Kühlkörperunterschale 202 und der Kühlkörperoberschale 204 kann sich eine Dichtung oder eine Klebemasse befinden. Die Kühlkörperunterschale 202 und die Kühlkörperoberschale 204 zusammen mit der Dichtung oder Klebemasse können beispielsweise durch Schrauben 206 oder Klippverbindung miteinander verpresst werden. Die Kühlkörperoberschale 204 umfasst z.B. einen Fluideingang und einen Fluidausgang, welche fluidisch mit den Durchgangsöffnungen 325, 326 der zweiten Kupplungseinheit 320 verbunden werden. Somit befindet sich an den Fluid-Ein-/Ausgängen an der Kühlkörperoberschale 204 die zweite Kupplungseinheit 320, wobei die Dichtigkeit zwischen den beiden vorab genannten Komponenten über zwei Axialdichtungen sichergestellt werden kann. In der zweiten Kupplungseinheit 320 befindet sich beispielsweise eine Langmutter zur Befestigung der zweiten Kupplungseinheit 320 an der Kühlkörperoberschale 204. Die zweite Kupplungseinheit 320 kann beispielsweise durch Schrauben sowohl an den Fluid-Ein-/Ausgängen als auch der Kühlkörperoberschale 204 befestigt werden.

Das zweite Modul 200 kann auf eine zu kühlende Einheit montiert werden. Im gezeigten Ausführungsbeispiel ist das zweite Modul 200 dazu ausgelegt, um auf oder an einem Prozessor, wie eine GPU oder eine CPU, angeordnet zu werden, der gekühlt werden soll. Falls eine GPU gekühlt werden soll, erfolgt der Einbau des zweiten Moduls 200 vorzugsweise über die GPU und parallel zur Grafikkarte 400. Im gezeigten Ausführungsbeispiel ist die Kühlkörperunterschale 202 oberhalb der GPU angeordnet. Die Bauhöhe der GPU ist typischerweise kleiner als die Bauhöhe anderer Komponenten. Daher ist hier hinreichend Platz vorhanden für das zweite Modul 200 und die Kupplungsvorrichtung 300. Insgesamt kann also durch die Bauform und die Positionierung der Kupplungsvorrichtung 300 oberhalb der GPU der Grafikkarte 400 und durch die Bauform des Kühlkörpers 210 sichergestellt werden, dass die gesamten Abmessungen, nämlich Grafikkarte plus Kühlkörper 210 plus Kupplungsvorrichtung 300, die Einbauraumrestriktionen von zwei PCle Slots (Peripheral Component Interconnect Express Slots) nicht überschreiten. Insgesamt kann also ein praxistaugliches, anwendungsfreundliches, stabiles und optisch ansprechendes System geschaffen werden.

Wie oben erwähnt, befinden sich in der zweiten Kupplungseinheit 320 zwei Signalschnittstellen 322, 323, welche z.B. als metallische Kontaktelemente ausgebildet sein können. Die Signalschnittstellen 322, 323 sind mit Signalleitungen 230, wie elektrischen Kabeln, verbunden. Die Signalleitungen 230 werden aus der zweiten Kupplungseinheit 320 geleitet und mit der zweiten Elektroplatine 220 verbunden. Die zweite Elektroplatine 220 befindet sich auf der Außenseite der Kühlkörperoberschale 204, und kann bei Bedarf ebenfalls durch diese gekühlt werden. Auf der zweiten Elektroplatine 220 sind eine zweite Steuereinheit 221, eine zweite Kommunikationseinheit 222 sowie ein Speicher 223 angeordnet.

Nachfolgend wird beschrieben, wie das erste Modul 100 und das zweite Modul 200 miteinander kommunizieren können.

Die erste Kommunikationseinheit 122 des ersten Moduls 100 ist ausgebildet zum Empfangen von Signalen von dem zweiten Modul 200. Weiter ist die zweite Kommunikationseinheit 222 des zweiten Moduls 200 dazu ausgebildet, Signale an das erste Modul 100 zu senden. Mit den Kommunikationseinheiten 122, 222 soll gewährleistet werden, dass nur systemkompatible Module/Komponenten zusammengebaut werden sollen. Zunächst können die Kommunikationseinheiten 122, 222 nur dann miteinander kommunizieren, wenn der Signalkreislauf über die Signalschnittstellen 322, 323, 366, 376 und die Signalleitungen 130, 230 hergestellt ist. Falls die Module 100, 200 entkoppelt sind, ist keine Kommunikation zwischen den Kommunikationseinheiten 122, 222 möglich, was durch die Kommunikationseinheiten 122, 222 oder die Steuereinheiten 121, 221 festgestellt werden kann. Somit kann mindestens eine der Kommunikationseinheiten 122, 222 und/oder mindestens eine der Steuereinheiten 121, 221 ausgebildet sein, anhand des Vorliegens der Verbindung der beiden Kommunikationseinheiten zu erkennen, ob die Kupplungsvorrichtung 300 in einem gekoppelten oder entkoppelten Zustand ist.

Im gekoppelten Zustand der Module 100, 200 und somit der Kupplungsvorrichtung sind die beiden Wärmetauscher der Module 100, 200 fluidisch über die Fluidleitungen miteinander verbunden. Die Steuereinheit 222 ist vorzugsweise ausgebildet, die Pumpe 110 nur dann anzuschalten oder anzusteuern, wenn die Kupplungsvorrichtung 300 im gekoppelten Zustand ist.

Alternativ oder zusätzlich kann als Sicherheitsvorkehrung vorgesehen sein, dass die Kommunikationseinheiten 122, 222 gemäß einem im Folgenden näher beschriebenen Kommunikationsprotokoll miteinander kommunizieren.

Nach Schließen des Signalkreislaufes kann die zweite Kommunikationseinheit 222 des zweiten Moduls 200 ausgebildet sein zum Senden eines Identifikationsmerkmals des zweiten Moduls 200 an die erste Kommunikationseinheit 122 des ersten Moduls 100. Das Identifikationsmerkmal kann zum Beispiel eine Seriennummer, eine bestimmte Verschlüsselung von Signalen und/oder eine bestimmte Kodierung von Signalen umfassen. Die Seriennummer ist in der Regel im Speicher 223 gespeichert. Die erste Kommunikationseinheit 122 ist ausgebildet zum Empfangen von Signalen des zweiten Moduls 200, und insbesondere zum Empfangen des Identifikationsmerkmals des zweiten Moduls 200. Die Steuereinheit 121 des ersten Moduls 100 kann anhand des Identifikationsmerkmals die Identität des zweiten Moduls 200 feststellen. Beispielsweise gleicht die Steuereinheit 121 die Seriennummer des zweiten Moduls 200 mit einer Liste von gespeicherten Seriennummern im Speicher 123 ab. Falls die Seriennummer des zweiten Moduls 200 in der Liste vorhanden ist und als systemkompatibel eingestuft ist, kann die Steuereinheit 121 feststellen, dass das zweite Modul systemkompatibel oder berechtigt ist. Falls jedoch die Seriennummer des zweiten Moduls nicht auf der Liste vorhanden ist oder als nicht systemkompatibel eingestuft ist, stellt die Steuereinheit 121 fest, dass das zweite Modul nicht systemkompatibel oder nicht berechtigt ist.

Außerdem kann die Steuereinheit 121 ausgebildet sein, anhand einer bestimmten Verschlüsselung und/oder Kodierung der Signale die Identität des zweiten Moduls 200 festzustellen. Es kann vorgesehen sein, dass lediglich ein hierfür konzipierter Datenblock verschlüsselt oder kodiert ist. In diesem Fall ist also nur ein Teil des Signals verschlüsselt oder kodiert. Der unverschlüsselte Teil des Signals kann z.B. Kodierungssignale, Sensorsignale, Steuerungssignale und/oder Regelungssignale umfassen. Es kann alternativ auch vorgesehen sein, dass das komplette Signal verschlüsselt ist. In diesem Fall können die Kodierungssignale, Sensorsignale, Steuerungssignale und/oder Regelungssignale verschlüsselt sein. Das erste Modul 100 und das zweite Modul 200 können jeweils eine hierfür ausgelegten Entschlüsselungsvorrichtung/Dekodierungsvorrichtung bzw. Verschlüsselungsvorrichtung/Kodierungsvorrichtung aufweisen.

Anschließend schaltet die Steuereinheit 121 die Pumpe 110 und/oder den Lüfter 140 nur dann an, wenn das zweite Modul 200 systemkompatibel oder berechtigt ist. Hierdurch kann z.B. vermieden werden, dass die Pumpe 110 oder der Lüfter 140 bei falsch angeschlossenen oder gefälschten Modulen aktiviert werden. Die Steuereinheit 121 kann weiter dazu ausgebildet sein, die Pumpe 110 und/oder Lüfter 140 in Abhängigkeit der Identität des zweiten Moduls 200 zu steuern. Hiermit kann z.B. die Leistung der Pumpe 110 oder des Lüfters 140 bedarfsgerecht an das zweite Modul 200 angepasst werden.

Die zweite Kommunikationseinheit 222 kann weiter dazu ausgestaltet sein Signale zu empfangen, beispielsweise von der ersten Kommunikationseinheit 122, von einer anderen zweiten Kommunikationseinheit 222 (falls mehrere zweite Module vorgesehen sind, s. unten) oder von einer Steuer- und Verarbeitungseinheit, wie einer CPU oder GPU. Falls die zu kühlende Einheit eine CPU oder eine GPU ist, kann die CPU oder GPU in der Regel ausgeben, wie hoch ihre momentane Taktgeschwindigkeit, Temperatur oder Leistung ist. Weiter stellen übliche CPUs oder GPUs eine Lüfterdrehzahl bereit, welche für die Steuerung eines für die Luftkühlung der CPU oder GPU vorhandenen Lüfters verwendet werden kann. Diese Kühlparameter können über weitere Signalleitungen (nicht dargestellt) an die zweite Kommunikationseinheit übermittelt werden. Die zweite Kommunikationseinheit 222 empfängt die Kühlparameter und leitet sie an die erste Kommunikationseinheit 122 in digitaler Form weiter. Nach Interpretation der Kühlparameter durch die erste Steuereinheit 121 wird die erste Steuereinheit 121 die Pumpe 110 und/oder den Lüfter 140 in Abhängigkeit dieser Kühlparameter ansteuern. Die Kühlparameter umfassen allgemein Sensordaten, Temperaturdaten, Energieverbrauchsdaten, Pumpenparameter, Wärmetauscherparameter, Steuerungssignale und/oder Regelungssignale.

Die Fig. 6 zeigt ein Fluidsystem 1, welches eine Vielzahl erster Module 100, 100' und eine Vielzahl zweiter Module 200, 200' aufweist. Im gezeigten Ausführungsbeispiel sind jeweils zwei erste Module 100, 100' und zwei zweite Module 200, 200' vorgesehen, wobei die Anzahl der ersten Module 100, 100' und die Anzahl der zweiten Module 200, 200' auch größer oder kleiner sein kann. Die ersten Module 100, 100' und die zweiten Module 200, 200' bilden einen geschlossenen Fluidkreislauf sowie einen geschlossenen Signalkreislauf. Hierzu sind die Fluidleitungen 102 der Module 100, 100', 200, 200' und die Signalleitungen der Module 100, 100', 200, 200' in Serie miteinander verbunden, was in der Fig. 6 durch gestrichelte Linien angedeutet ist. Die Signalleitungen sind hierbei als Eindraht-Bus-System ausgestaltet. Die ersten Module 100, 100' können als Master-Module bezeichnet werden, während die zweiten Module 200, 200' als Slave-Module bezeichnet werden können.

Falls mehrere Module 100, 100', 200, 200' miteinander verbunden werden sollen, kann mindestens eine Erweiterungsleitung 390, 391 vorgesehen sein. In der Fig. 6 sind zwei Erweiterungsleitungen 390, 391 gezeigt, welche die Module 200, 200' miteinander verbinden und dabei die Fluidverbindung und die Signalübertragung der Module 200, 200' ermöglichen. Weiter sind die Erweiterungsleitungen 390, 391 miteinander verbunden. An einem ersten Ende 392 der Erweiterungsleitung 390 kann das oben beschriebene erste Teilgehäuse 362 befestigt sein, während an einem dem ersten Ende gegenüberliegenden zweiten Ende 393 der Erweiterungsleitung 390 das oben beschriebene zweite Teilgehäuse 364 befestigt sein kann. Dementsprechend ist ein zweites Ende 394 der Erweiterungsleitung 391 mit dem Teilgehäuse 364 versehen und mit dem ersten Ende 392 der Erweiterungsleitung 390 verbunden. An einem ersten Ende 395 der Erweiterungsleitung 391 ist das erste Teilgehäuse 362 angeordnet. Die Erweiterungsleitungen 390, 391 umfassen jeweils eine Fluidleitung und eine Signalleitung, die die Durchgangsöffnungen bzw. Signalschnittstellen der Teilgehäuse 362, 364 der Erweiterungsleitungen 390, 391miteinander verbinden. Im Ausführungsbeispiel der Fig. 6 wurden zur Anschaulichkeit auf das axiale Fixierelement 380 zur Verbindung der Erweiterungsleitungen 390, 391 verzichtet. Selbstverständlich können die Erweiterungsleitungen 390, 391 bevorzugt ebenfalls mit einem axialen Fixierelement 380 aneinander gekoppelt werden.

Bevor die Pumpen 110 der ersten Module 100, 100' anfangen zu pumpen, sollte unter anderem geprüft werden, ob ein geschlossener Fluidkreislauf vorliegt, mit welcher Leistung die Pumpen 110 der Module 100, 100' arbeiten sollen, ob systemkompatible Module vorliegen und welche Module 100, 100', 200, 200' miteinander verbunden sind. Hierzu senden die zweiten Kommunikationseinheiten 222 der zweiten Module 200, 200' ihre Identifikationsmerkmale an die ersten Kommunikationseinheiten 122 der ersten Module 100, 100'. Signale, die von anderen Modulen stammen, können weitergeleitet werden. Falls z.B. das in der Fig. 6 gezeigt zweite Modul 200' eine Signalfolge von dem zweiten Modul 200 erhält, ist die Kommunikationseinheit 222 ausgebildet, die Signale an die erste Kommunikationseinheit 122 des ersten Moduls 100' weiterzuleiten. In ähnlicher Weise kann die Kommunikationseinheit 122 des Moduls 100' die Signale des zweiten Moduls 200' an das erste Modul 100 weiterleiten.

Die ersten Module 100, 100' stimmen untereinander ab, welches Modul 100 oder 100' die gesamte Systemsteuerung übernimmt. Dies kann z.B. anhand der Seriennummern der ersten Module 100, 100' geschehen. Es kann z.B. vorgesehen sein, dass das erste Modul 100 mit der höchsten Seriennummer oder alternativ der niedrigsten Seriennummer die Systemsteuerung übernimmt und somit auch das jeweils andere erste Modul 100' bzw. dessen Pumpe 110 und dessen Lüfter 140 ansteuert. Dieses Modul 100, bzw. die Steuereinheit 121 dieses Moduls 100, kann dann ausgebildet sein zum Auswerten und/oder Vergleichen der Kühlparameter von allen zweiten Modulen 200, 200' und zum Steuern der Pumpen 110 und der Lüfter 140 basierend auf der Auswertung und/oder dem Vergleich. Falls die durch das zweite Modul 200 gekühlte GPU eine Temperatur von 40 °C anzeigt, während die durch das zweite Modul 200' gekühlte GPU eine Temperatur von 50 °C hat, können die Pumpen 110 der Module 100, 100' basierend auf dem höchsten gemessenen Temperaturwert angesteuert werden. Weiter können die Pumpen 110 der Module 100, 100' auch angesteuert werden basierend auf der höchsten Seriennummer der zweiten Module 200, 200'.

Es versteht sich, dass die in den Figuren dargestellten und oben beschriebenen Ausführungsformen miteinander kombiniert werden können, sofern sich die Kombinationen nicht gegenseitig ausschließen. Merkmale, die nur in Bezug auf die oben beschriebene Kupplungsvorrichtung 300 genannt wurden, können auch für das erste Modul 100, 100', das zweite Modul 200, 200' oder das oben beschriebene Fluidkühlsystem 1 beansprucht werden und andersherum.

### Bezugszeichenliste:

- 1: Fluidkühlsystem
- 100: erstes Modul
- 100': erstes Modul
- 102: Fluidleitungen
- 104: kupplungsseitiges Ende
- 105: elektrisch leitender Ring
- 106: radiatorseitiges Ende
- 108: Anschlussnippel
- 109: Anschlussnippel
- 110: Pumpe
- 111: Radiator
- 112: Kabelverbund
- 114: Elektroplatine
- 120: erste Elektroplatine
- 121: erste Steuereinheit
- 122: erste Kommunikationseinheit
- 123: Speicher
- 130: Signalleitung
- 140: Lüfter
- 141: Kabelverbund
- 200: zweites Modul
- 200': zweites Modul
- 202: Kühlkörperunterschale
- 204: Kühlkörperoberschale
- 206: Schrauben
- 210: Kühlkörper
- 220: zweite Elektroplatine
- 221: zweite Steuereinheit
- 222: zweite Kommunikationseinheit
- 223: zweiter Speicher
- 230: Signalleitung
- 300: Kupplungsvorrichtung
- 310: erste Kupplungseinheit
- 314: Schnellverschlusseinheit
- 320: zweite Kupplungseinheit
- 322: Signalschnittstelle
- 323: Signalschnittstelle
- 324: Schnellverschlusseinheit
- 325: dritte Durchgangsöffnung
- 326: vierte Durchgangsöffnung
- 327: Stirnfläche
- 330: Schraube
- 360: erstes Gehäuse
- 361: zweites Gehäuse
- 362: erstes Teilgehäuse
- 363: Rücksprung
- 364: zweites Teilgehäuse
- 365: erste Durchgangsöffnung
- 366: erste Signalschnittstelle
- 367: erste Stirnfläche
- 368: erste Seitenfläche
- 369: Profil
- 370: Schraubenöffnung
- 371: Öffnung
- 373: Vorsprung
- 375: zweite Durchgangsöffnung
- 376: zweite Signalschnittstelle
- 377: zweite Stirnfläche
- 378: zweite Seitenfläche
- 380: axiales Fixierelement
- 381: Seitenfläche
- 390: Erweiterungsleitung
- 391: Erweiterungsleitung
- 392: erstes Ende der Erweiterungsleitung 390
- 393: zweites Ende der Erweiterungsleitung 390
- 394: erstes Ende der Erweiterungsleitung 391
- 395: zweites Ende der Erweiterungsleitung 391
- 400: elektronische Bauteile

## Patentansprüche

1. Erstes Modul, insbesondere für ein Fluidkühlsystem, umfassend eine Steuereinheit, eine erste Kommunikationseinheit, eine Pumpe für ein Kühlfluid, und einen ersten Wärmetauscher,
wobei die erste Kommunikationseinheit ausgebildet ist zum Empfangen von Signalen von mindestens einem zweiten Modul, wobei die Signale ein Identifikationsmerkmal des zweiten Moduls aufweisen,
wobei die Steuereinheit anhand des Identifikationsmerkmals ausgebildet ist zum
- Identifizieren des zweiten Moduls,
- Überprüfen, ob das zweite Modul systemkompatibel oder berechtigt ist, und
- Anschalten der Pumpe und/oder des ersten Wärmetauschers in Abhängigkeit eines Vorliegens des systemkompatiblen oder berechtigten zweiten Moduls.

2. Erstes Modul nach Anspruch 1, wobei das Identifikationsmerkmal eine Seriennummer des zweiten Moduls umfasst.

3. Erstes Modul nach einem der vorstehenden Ansprüche, wobei die Steuereinheit ausgebildet ist, anhand einer bestimmten Verschlüsselung und/oder Kodierung der Signale die Identität des zweiten Moduls festzustellen.

4. Erstes Modul nach einem der vorstehenden Ansprüche, wobei die Steuereinheit ausgebildet ist, die Pumpe und/oder den ersten Wärmetauscher in Abhängigkeit der Identität des zweiten Moduls zu steuern.

5. Erstes Modul nach einem der vorangehenden Ansprüche, wobei die Signale Kühlparameter umfassen, und die Steuereinheit ausgebildet ist, die Pumpe und/oder den ersten Wärmetauscher in Abhängigkeit der Kühlparameter anzusteuern.

6. Zweites Modul, insbesondere für ein Fluidkühlsystem, umfassend einen zweiten Wärmetauscher, welcher mit einer zu kühlenden Einheit verbindbar ist, und eine zweite Kommunikationseinheit,
wobei die zweite Kommunikationseinheit ausgebildet ist:
zum Senden eines Identifikationsmerkmals des zweiten Moduls an eine erste Kommunikationseinheit eines ersten Moduls.

7. Zweites Modul nach Anspruch 6, wobei das Identifikationsmerkmal eine Seriennummer, eine bestimmte Verschlüsselung oder eine bestimmte Kodierung von Signalen umfasst.

8. Zweites Modul nach einem der Ansprüche 6 oder 7, wobei das zweite Kommunikationseinheit ausgebildet ist, Signale zu empfangen und an die erste Kommunikationseinheit weiterzuleiten.

9. Zweites Modul nach einem der Ansprüche 6 bis 8, wobei die zweite Kommunikationseinheit ausgebildet ist, Kühlparameter der zu kühlenden Einheit zu empfangen und die genannten Kühlparameter an die erste Kommunikationseinheit zu senden.

10. Erstes oder zweites Modul nach Anspruch 5 oder Anspruch 9, wobei die Kühlparameter Sensordaten und/oder Temperaturdaten und/oder Energieverbrauchsdaten und/oder Pumpenparameter und/oder Wärmetauscherparameter und/oder Steuerungssignale und/oder Regelungssignale umfassen.

11. Fluidkühlsystem, umfassend das erste Modul und das zweite Modul gemäß den vorstehenden Ansprüchen, Kühlfluidleitungen, Signalleitungen und eine Kupplungsvorrichtung zum Verbinden des ersten Moduls mit dem zweiten Modul, wobei die Kupplungsvorrichtung ausgestaltet ist, durch Kupplung der Kühlfluidleitungen den ersten Wärmetauscher und den zweiten Wärmetauscher fluidisch miteinander zu verbinden und durch Kupplung der Signalleitungen die erste Kommunikationseinheit und die zweite Kommunikationseinheit miteinander zu verbinden.

12. Kühlfluidsystem nach Anspruch 11, umfassend eine Vielzahl erster Module und/oder eine Vielzahl zweiter Module, wobei die Fluidleitungen und die Signalleitungen der Module seriell miteinander verbindbar oder verbunden sind.

13. Kühlfluidsystem nach Anspruch 12, wobei die Steuereinheiten der ersten Module ausgebildet sind, die Pumpen oder Wärmetauscher gemäß einem vorbestimmten Protokoll, insbesondere basierend auf Seriennummern der ersten Module und/oder der zweiten Module, anzusteuern.

14. Kühlfluidsystem nach einem der Ansprüche 12 oder 13, wobei die Vielzahl zweiter Module Kühlparameter an die erste Kommunikationseinheit senden, und die Steuereinheit des ersten Moduls ausgebildet ist zum
- Auswerten und/oder Vergleichen der Kühlparameter der zweiten Module,
- Steuern der Pumpe und/oder des ersten Wärmetauschers basierend auf der Auswertung und/oder dem Vergleich.

15. Kühlfluidsystem nach einem der Ansprüche 11 bis 14, wobei die Signalleitungen als Eindraht-Bussystem ausgestaltet sind.
